# EUROPEAN PATENT APPLICATION

(11) **EP 2 603 064 A1**
(43) Date of publication of application: **12.06.2013**
(21) Application number: 11192516.0
(22) Date of filing: 08.12.2011
(51) Int. Cl.: H05K 3/38, H05K 3/06

(54) **Multilayer printed circuit board manufacture**

(71) Applicant: Atotech Deutschland GmbH, 10553 Berlin (DE)
(72) Inventor: Tews, Dr. Dirk, 10318 Berlin (DE); Zee, Adrian, 10629 Berlin (DE); Hülsmann, Thomas, 14167 Berlin (DE); Kim, Kwonil, Kyounggi-do (KR)
(74) Representative: Wonnemann, Jörg

(57) **Abstract**

The present invention relates to a method for manufacture of multilayer printed circuit boards and articles formed thereby, especially IC substrates. The method utilizes a copper-tin alloy layer coated with at least one silane binding agent to provide adhesion between a copper surface and a resin layer after lamination. This method leads to an enhanced adhesive strength, improved mechanical and thermal stress resistance as well as humidity resistance of multilayer printed circuit boards and IC substrates.

## Description

### Field of the Invention

The present invention relates to a method for forming a multilayer printed circuit board or an IC substrate.

### Background of the Invention

Multilayer printed circuit boards, IC substrates and the like are laminates in which metal layers and resin layers alternate. Usually, the metal layers are made of copper and the resin layers are made of an organic material or a fiber-reinforced organic material or a particle-reinforced organic material, etc., for example, epoxy resin, polyimide, bismeleimide triazine resin, cyanate ester, polybenzocyclobutene, or glass fiber composite thereof, etc.

During manufacture, the resin layer is laminated onto a copper layer by applying heat and pressure to the assembly. A modification of the copper surface is required prior to the lamination step in order to achieve a sufficient adhesion between the copper layer and the resin layer after said lamination step.

Established methods for modification of the copper surface prior to the lamination step comprise treatments wherein firstly a copper oxide or metallorganic compounds containing copper is formed on the surface of the copper layer and secondly a resin layer is laminated thereon. A disadvantage of such methods is caused by etching of copper associated with forming the copper oxide or metallorganic compound layer. In case the copper layer is a fine line pattern having e.g. a line width of 20 µm and an inter line distance of 20 µm, too much copper can be etched away during such a treatment.

Alternative methods to improve adhesion between a copper layer and a resin layer comprise formation of a tin layer on the surface of the copper layer prior to the lamination step.

Document EP 0 431 501 B1 discloses a process for manufacturing multilayer printed circuit boards using organosilane bonding mixtures applied to oxidized tin surfaces. Said process fails in the manufacture of fine-line IC substrates having an inter line distance of 20 µm or less because the line shape of the copper circuitry is altered (expanded) by the tin layer deposited thereon.

Document US 2009/0197109 A1 discloses a method for improving the adhesion between a copper layer and a dielectric layer by forming a tin layer on the surface of the copper layer by immersion plating of tin. A copper-tin alloy layer is thereby formed between the copper layer and the tin layer. The tin layer is removed until the surface of the copper-tin alloy layer is exposed. Next, a resin layer is laminated onto the copper-tin alloy layer. Said process fails in the manufacture of fine-line IC substrates due to an insufficient adhesion between the copper circuitry and the resin layer.

### Objective of the Invention

Therefore, it is the objective of the present invention to provide a method for multilayer printed circuit board manufacture wherein the treatment of the copper surface prior to laminating a resin layer thereon leads to a sufficient adhesion between the copper surface and a resin layer after lamination in a humid environment and wherein the line shape of the copper circuitry is maintained.

### Summary of the Invention

This objective is solved by a method for manufacture of printed circuit boards comprising, in this order, the steps of
a. providing a substrate having a copper surface,
b. depositing a layer of tin by immersion plating and thereby forming a copper-tin alloy layer between the copper surface and the tin layer,
c. removing the tin layer formed in step b and thereby exposing the copper-tin alloy layer,
d. depositing at least one silane binding agent onto the copper-tin alloy layer and thereby forming a silane coating and
e. laminating a resin layer onto the copper surface whereby the silane coating is between the copper-tin alloy layer and the resin layer.

By applying the method according to the present invention, a sufficient adhesion between a copper surface and a resin layer is achieved after lamination, especially in a humid environment.

The method according to the present invention is particularly suitable for circuits possessing high-density interconnect (HDI) feature sizes of 50 µm and even 25 µm or lower.

### Detailed Description of the Invention

In formation of multilayer printed circuit boards or IC substrates several dozen conductive and resin layers can be employed. Also, for formation of multilayer circuit boards or IC substrates, it is necessary to drill holes and defects can occur due to delamination of layers in the areas immediately surrounding a hole. If a defect is present in one of the layers or if delamination occurs, generally the entire board or IC substrate must be scrapped. Therefore high quality in each of the steps of formation of the printed circuit board or IC substrate is essential for commercial production.

Illustratively one article can contain in order, a dielectric layer, a copper circuitry with a layer of copper-tin alloys, a layer comprising at least one silane binding agent (the silane coating), a resin layer, a second dielectric layer, a second copper circuitry with a second layer of copper-tin alloys, a second layer comprising at least one silane binding agent (second silane layer) and a second resin layer. In the above article the (first) resin layer can be contacted to the second dielectric layer directly or through an adhesive layer. Such adhesives are well known in the art, e.g., a high temperature epoxy.

In an alternative article the second dielectric layer need not be present with all other layers having the same order. In a further alternate embodiment of the invention a dielectric layer can be present which has copper circuitry on opposite surfaces. Thereafter on the opposite surface the various layers are applied including optionally a layer of copper-tin alloys, at least one silane binding agent and a resin layer.

A starting material in the process of the present invention is a dielectric layer which contains on one or opposite surfaces a copper layer. This copper layer has a thickness in the range of 0.8 to 25 µm and it is used to form conductive circuitry. Well-known techniques in the prior art can be employed to form such circuitry such as by photoimaging technique of a photosensitive resist film followed by etching of unprotected areas of the copper. An example of a suitable technique is disclosed in U.S. Patent 3,469,982. The composition of the dielectric layer is not critical provided it functions as an electrical insulator. Useful support materials are disclosed in U.S. Patent 4,499,152 such as epoxy reinforced with glass fiber. Preferably a partially cured thermosetting polymer composition is employed which is known in the art as a prepreg or "B" stage resin. Useful dielectric substrates or resin layers may be prepared by impregnating woven glass reinforcement materials with partially cured resins, usually epoxy resins (e.g., difunctional, tetrafunctional and multifunctional epoxies). Epoxy resins are particularly suited. It is an advantage of the at least one silane binding agent of the present invention that they show very good adhesion on both glass and resin areas of the resin layer to be laminated onto the copper circuitry.

Examples of useful resins for the dielectric layer and the resin layer include amino-type resins produced from the reaction of formaldehyde and urea, or formaldehyde and melamine, epoxy resins, polyesters, phenolics, silicones, polyamides, polyimides, di-allyl phthalates, phenylsilanes, polybenzimidazoles, diphenyloxides, polytetrafluoroethylenes, cyanate esters, etc. These materials often are referred to as prepregs. Epoxy substrate materials of the newest generation are GX-13 and GX-92, both manufactured by Ajinomoto, which contain glass ball fillers and are suitable as a resin layer. The resin layer and the dielectric layer can be prepared by impregnating woven glass reinforcement materials with partially cured resins as described above. Thus, the resin layer or layers may also be prepregs.

In the formation of multilayer printed circuit boards or IC substrates, several dielectric layers having a copper circuitry on at least one surface and several resin layers may be employed.

A layer of tin is deposited onto the copper circuitry by immersion plating. Alternatively, a tin-alloy layer such as a tin-silver alloy layer instead of a tin layer is deposited onto the copper circuitry.

A suitable plating bath for immersion plating of tin comprises a source of tin ions and at least one complexing agent such as citric acid. Preferably, the plating bath further comprises thiourea or a derivative thereof. Metal ions such as silver ions are added to such a plating bath in case a tin alloy such as a tin-silver alloy is to be deposited. Acidic immersion tin plating baths comprising thiourea or derivatives thereof are known since a long time (The Electrodeposition of Tin and its Alloys, M. Jordan, Eugen G. Leuze Publishers, 1995, pages 89 to 90 and references cited therein).

The substrate to be coated is for example first cleaned in an acidic cleaner and then contacted with the immersion tin or tin alloy plating bath according to the present invention. The temperature of the immersion tin or tin alloy plating bath during use ranges from 35 to 85 °C. The substrate immersion time in the immersion tin or tin alloy plating bath ranges from 1 to 60 min.

The thickness of the tin layer which is deposited by immersion plating onto the copper circuitry in step b ranges from 0.005 to 1.5 µm. More preferably, the thickness of the tin layer deposited in step b. ranges from 0.01 to 0.1 µm.

During immersion plating of tin (or a tin alloy) onto the copper circuitry a copper-tin (or copper-tin-metal alloy) is automatically formed between the copper circuitry and the tin layer (or tin alloy layer). This is known in the art and for example described in "The Electrodeposition of Tin and its Alloys", M. Jordan, Eugen G. Leuze Publishers, 1995, pages 89 to 90 and references cited therein. The thickness of the copper-tin alloy layer (or copper-tin-metal alloy layer) ranges from 0.001 to 0.05 µm, more preferably from 0.001 to 0.02 µm, depending on the thickness of the tin layer deposited by immersion plating in step b. The copper-tin alloy layer typically comprises Cu₃Sn and Cu₅Sn₆ phases.

Next, the tin layer (or tin alloy layer) formed in the previous step of the method according to the present invention is removed. Preferably, wet chemical etching is employed to remove the tin layer (or tin alloy layer). Suitable wet chemical etching compositions are either aqueous acidic and aqueous alkaline etching compositions suitable for removing tin.

Suitable acidic etchant for tin are acids or mixtures of acids such as sulfuric acid, nitric acid and hydrochloric acid diluted with water. The concentration of the at least one acid in a suitable acidic etchant for tin ranges from 0.1 to 10 wt.-%.

Suitable alkaline etchants are for example aqueous solutions having a pH value of ≥ 7 and comprising hydroxide ions and at least one etching additive.

Hydroxide ions may be generated in the alkaline etchant by adding one or more of LiOH, NaOH, KOH, NH₄OH, Na₂CO₃, K₂CO₃ and organic hydroxide sources such as ethanolamine, diethanolamine, triethanolamine and imidazole.

The at least one etching additive is selected from the group comprising nitro-substituted aromatic sulfonic acids and ClO₂⁻ ions. The preferred nitro-substituted aromatic sulfonic acids are selected from the group consisting of o-nitrobenzene sulfonic acid, m-nitrobenzene sulfonic acid, p-nitrobenzene sulfonic acid and their corresponding salts with sodium and potassium and mixtures thereof. ClO₂⁻ ions may be added as an alkali salt such as Na(ClO₂).

The concentration of hydroxide ions in the alkaline etchant ranges from 0.5 to 100 g/I, more preferably from 10 to 40 g/I and most preferably from 20 to 30 g/I.

The concentration of the etching additive in the alkaline etchant ranges from 1 to 100 g/l, more preferably from 20 to 80 g/I and most preferably from 40 to 60 g/I.

Preferably, the layer of tin is selectively etched away in step c without substantially etching away the copper-tin alloy layer and the copper layer.

Alkaline etchants are preferred, because both the underlying copper-tin alloy layer and the copper layer can not be etched (i.e. damaged) by such alkaline etchants. Instead, only tin is etched away by the above described alkaline etchants.

In case the substrate is too long contacted with an acidic etchant, the underlying copper-tin alloy layer and the copper layer can be damaged by etching.

The tin plated copper circuitry is treated for 5 to 120 s with the etchant in order to remove the tin layer from the copper circuitry and thereby exposing the copper-tin alloy layer underneath the tin layer. The temperature of the etchant is held between 20 and 80 °C, more preferably between 30 to 40 °C. Etching of the tin layer can be achieved for example by dipping the substrate having a tin plated copper circuitry into the etchant or by spraying the etchant onto the tin plated copper circuitry.

Next, at least one silane binding agent is deposited onto the copper-tin alloy and thereby a silane coating is formed. The at least one silane binding agent is preferably dissolved in water, an alcohol or a water-alcohol mixture. Hence, a silane solution is used to deposit the at least one silane binding agent onto the copper-tin alloy layer. The overall concentration of silane binding agents in said solution ranges between 1 g/I and 50 g/I, more preferred from 2 g/I to 10 g/I. The at least one silane binding agent in the solution can be deposited onto the copper-tin alloy layer by any conventional means, e.g., by dipping, spraying, brushing and immersion.

The at least one silane binding agent is selected from water-reducible silanes which can either be water-reducible monomeric silanes such as an epoxy-functionalized trialkoxy silane or a water-reducible oligomeric silane binding agent such as an epoxy-functionalized trialkoxy silane which was (partially) hydrolized and condensed to form oligomeric siloxanes prior to deposition of the silane binding agent onto the copper-tin alloy surface.

Suitable water-reducible silane binding agents are selected from the group comprising tetraalkoxy silanes such as tetramethoxy silane and tetraethoxy silane and respective partially or fully hydrolyzed silanes and oligomers derived thereof; trialkoxy silanes having one organic functional group selected from alkyl, amino, epoxy, methacryloxy, ureido, allyl and vinyl and respective partially or fully hydrolized silanes and oligomers derived thereof.

Preferably, the organic functional group of the water-reducible silane binding agent is selected from the group consisting of amino, epoxy, methacryl, ureido and vinyl.

Most preferably, the organic functional group of the water-reducible silane binding agent is selected from the group consisting of amino, epoxy and ureido.

Suitable water-reducible trialkoxy silane binding agents having one organic functional group are for example methyltriethoxy silane, vinyltrimethoxy silane, vinyltriethoxy silane, methacryloxypropyltrimethoxy silane, methacryloxypropyltriethoxy silane, 3-amino-propyltrimethoxy silane, 3-amino-propyltrimethoxy silane, 3-amino-propyltriethoxy silane, beta-(3,4-epoxycyclo-hexyl)-ethyltrimethoxy silane, beta-(3,4-epoxycyclohexyl)-ethyltriethoxy silane, 4-(trimethoxy-silyl)-butane-1,2-epoxide, 4-(triethoxy-silyl)-butane-1,2-epoxide, gamma-glycidoxypropyltrimethoxy silane, gamma-glycidoxypropyltriethoxy silane, ureidoproyltrimethoxy silane, ureidopropyltriethoxy silane, allyltrimethoxy silane, allyltriethoxy silane and respective partially and fully hydrolyzed silanes and oligomers derived thereof.

The hydrolysis and condensation of water-reducible monomeric silanes is well known in the art. For example, the monomeric silane is reacted with an acidic catalyst, for example, acetic acid or diluted hydrochloric acid leading to a clear solution of water-reducible oligomeric silanes derived from the water-reducible monomeric silanes. The solution of water-reducible oligomeric silane molecules is then deposited onto the surface of the copper-tin alloy surface in step d.

Suitable oligomeric silanes are for example aminosilanes such as Dynasilan® Hydrosil 1151 (a water-reducible oligomeric silane derived from 3-aminopropyltrialkoxysilan), Dynasilan® Hydrosil 2627 (a water-reducible oligomeric siloxane), Dynasilan® Hydrosil 2909 (Amino/alkyl), Dynasilan® Hydrosil 2776 (diamino) all manufactured by Evonik.

Next, a resin layer is attached to the silane coating and the whole assembly comprising the dielectric layer, the copper circuitry, the copper-tin alloy layer, the silane coating and the resin layer is laminated to form a multilayer assembly.

The multilayer printed circuit boards or IC substrates prepared as described above may be subjected to conventional lamination temperatures and pressures between plates of lamination presses. In this manner, the laminating operation generally will involve pressures in the range of from 1.72 MPa to 5.17 MPa, temperatures in the range of from 130 °C to about 350 °C and laminating cycles of from 30 min to 240 min.

In another embodiment of the present invention, a vacuum lamination method is used for build-up films in IC substrates. The resin layer is placed on the copper surface, laminated at for example 100 °C and meanwhile pressed for 30 s by at 0.5 MPa.

The advantages of the method according to the present invention include enhanced adhesion, enhanced oxidation resistance and enhanced moisture resistance, especially for high density interconnects and IC substrates.

### Examples

Test samples used throughout all examples:
(i) full copper board panels built from standard FR4 material comprising a dielectric layer of 0.8 mm thickness and a copper layer thickness of 35 µm and a size of 310 x 500 mm as substrate having a copper circuitry and
(ii) ABF films (GX-92, manufactured by Ajinomoto) having a thickness of 25 µm as the resin layer laminated in step (e).

The copper surface of the full copper board panels were chemically cleaned in all examples. Next, a layer of tin was deposited by immersion plating onto the cleaned copper surface.

In all experiments panels of type (i) are laminated with ABF films as the resin layer. Before lamination the panels are pre-warmed at 65 °C for 5 min. The lamination is done with a vacuum laminator at 100 °C at 5 bar. The lamination of both panel sides requires two lamination steps. Afterwards the PET cover foil is removed.

The process steps applied in the examples is summarized in table 1:

| **Process step** | **Temperature [°C]** | **Process time [s]** | **Composition** |
|---|---|---|---|
| **Chemical cleaning:** | | | |
| Acidclean UC (a product of Atotech Deutschland GmbH) | 35 | 17 | Acidic cleaner |
| Rinse | 25 | 35 | Water |
| **Immersion tin treatment according to step b:** | | | |
| Secure Enhancer MSA (a product of Atotech Deutschland GmbH) | 35 | 35 | Comprising Sn²⁺ ions, MSA and thiourea |
| Rinse | 25 | 35 | Water |
| Rinse | 25 | 17 | DI water |
| **Etch Back according to step c (not applied in Example 1):** | | | |
| Etch Back | 30 | 30 | Either acidic or alkaline etchant |
| **Deposition of the silane binding agent according to step d (not applied in Example 2):** | | | |
| Secure 1000PT (a product of Atotech Deutschland GmbH) | 30 | 35 | Ureido-trialkoxy silane |
| **Lamination of the resin layer according to step e:** | | | |
| Vacuum lamination | 100 °C | 5 bar for 30 s | GX-92 (manufactured by Ajinomoto) |
| Final curing | 190 °C | 90 min | |

All samples are then subjected to an accelerated moisture resistance test according to the JEDEC Standard JESD22-A118, test condition A (130 ±2 °C and a relative humidity of 85 ± 5 % applied to the samples for 96 h). This standardised test procedure is also referred as HAST (highly accelerated stress test).The peel strength is then determined in accordance with IPC-TM-650 No. 2.4.8.

### Example 1 (comparative, according to EP 0 431 501 B1)

The tin layer deposited in step b and having a thickness of 1 µm was not removed prior to deposition of the silane binding agent. The silane binding agent applied in step d was an ureidotrialkoxy silane dissolved in water.

The peel strength determined after lamination was 9.97 N/cm. The peel strength determined after the HAST treatment was 9.9 N/cm.

### Example 2 (comparative, according to US 2009/0197109 A1)

The tin layer deposited in step b was removed with an acidic etchant (0.15 wt.-% nitric acid) and directly thereafter the resin layer was laminated without a silane binding agent.

The peel strength determined after lamination was 6.5 N/cm. The laminate was not stable during the HAST treatment, i.e., a delamination of the panel of type (i) and the ABF film of type (ii) occurred. Hence, such a laminate can not be used in practice.

### Example 3 (acidic etchant)

The tin layer deposited in step b was removed with an acidic etchant (0.15 wt.-% nitric acid). Next, a silane binding agent (aqueous solution of an ureido-trialkoxy silane) was deposited onto the etched surface followed by successive lamination of the resin layer.

The peel strength determined after lamination was 9.42 N/cm. The peel strength determined after the HAST treatment was 7.34 N/cm.

### Example 4 (alkaline etchant)

The tin layer deposited in step b was removed with an alkaline etchant (aqueous solution of 10 g/l NaOH and 25 g/I m-nitrobenzene sulfonic acid). Next, a silane binding agent (aqueous solution of an ureidotrialkoxy silane) was deposited onto the etched surface followed by successive lamination of the resin layer.

The peel strength determined after lamination was 9.69 N/cm. The peel strength determined after the HAST treatment was 9.58 N/cm.

## Claims

1. Method for manufacture of printed circuit boards, comprising, in this order, the steps of
a. providing a substrate having a copper surface,
b. depositing a layer of tin by immersion plating and thereby forming a copper-tin alloy layer between the copper surface and the tin layer,
c. removing the tin layer formed in step b and thereby exposing the copper-tin alloy layer,
d. depositing at least one silane binding agent onto the copper-tin alloy layer and thereby forming a silane coating and
e. laminating a resin layer onto the copper surface whereby the silane coating is between the copper-tin alloy layer and said resin layer.

2. Method for manufacture of printed circuit boards according to claim 1 wherein the copper-tin alloy layer has a thickness of 0.001 to 0.02 µm.

3. Method for manufacture of printed circuit boards according to any of the foregoing claims wherein the layer of tin is selectively etched away in step c without substantially etching away the copper-tin alloy layer and the copper layer.

4. Method for manufacture of printed circuit boards according to any of the foregoing claims wherein the tin or tin-metal alloy layer formed in step b is removed by wet chemical etching in step c.

5. Method for manufacture of printed circuit boards according to any of the foregoing claims wherein the wet chemical etching composition applied in step c has a pH value ≥ 7 and comprises hydroxide ions.

6. Method for manufacture of printed circuit boards according to claim 5 wherein the wet chemical etching composition further comprises an etching additive selected from the group comprising nitro-substituted aromatic sulfonic acids and ClO₂⁻ ions.

7. Method for manufacture of printed circuit boards according to any of the foregoing claims wherein the silane deposited in step d is selected from the group comprising water-reducible monomeric silanes and water-reducible oligomeric silanes.

8. Method for manufacture of printed circuit boards according to any of the foregoing claims wherein the silane deposited in step d is selected from the group comprising trialkoxy silanes having one organic functional group selected from alkyl, amino, epoxy, methacryloxy, ureido, allyl and vinyl and respective partially or fully hydrolized silanes and oligomers derived thereof.

9. Method for manufacture of printed circuit boards according to any of the foregoing claims wherein the resin layer comprises an epoxy resin.
